# EUROPEAN PATENT APPLICATION

(11) **EP 4 692 815 A1**
(43) Date of publication of application: **11.02.2026**
(21) Application number: 24823530.1
(22) Date of filing: 28.03.2024
(51) Int. Cl.: G01R 31/367, G01R 31/392, G01R 31/396, G01R 31/36, G01R 31/382, G01R 31/385, H01M 10/48, B60L 58/10, G06N 20/10, G06N 3/0442

(54) **BATTERY DIAGNOSIS APPARATUS AND METHOD**

(30) Priority: 15.06.2023 KR 20230076815
(71) Applicant: LG Energy Solution, Ltd., Seoul 07335 (KR)
(72) Inventor: PARK, Jhin Ha, Daejeon 34122 (KR); KIM, Young Jin, Daejeon 34122 (KR); JIN, Hee Jun, Daejeon 34122 (KR); BYEON, Min Jeong, Daejeon 34122 (KR); CHOI, Jee Soon, Daejeon 34122 (KR); KWON, Min Ho, Daejeon 34122 (KR)
(74) Representative: Plasseraud IP
(86) International application number: PCT/KR2024/003918
(87) International publication number: WO 2024/258009

(57) **Abstract**

A battery diagnosis apparatus includes a sensor configured to measure battery test data from a diagnosis target battery and a processor configured to classify the battery test data into a plurality of charging/discharging state data sets based on a plurality of reference values related to a plurality of charging/discharging states, perform preliminary defect diagnosis for each of the plurality of charging/discharging state data sets based on a preliminary diagnostic model, and determine the diagnosis target battery as a final defect based on a result of the preliminary defect diagnosis.

## Description

### [TECHNICAL FIELD]

### CROSS-REFERENCE TO RELATED APPLICATION

This application claims priority to and the benefit of Korean Patent Application No. 10-2023-0076815 filed in the Korean Intellectual Property Office on June 15, 2023, the entire content of which is incorporated herein by reference.

### TECHNICAL FIELD

Embodiments disclosed herein relate to a battery diagnosis apparatus and method.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Various diagnostic models may be used to diagnose whether battery cells, modules, packs, etc. operate normally. For example, during application of a charging/discharging test voltage, the test voltage may be measured from a battery to be diagnosed, and for this end, a diagnosis model may be applied to diagnose whether the battery has a defect. Indices such as a diagnosis rate (a sorting power) indicating a rate at which the diagnostic models operating in this way correctly diagnose defects, a false positive rate indicating a rate at which the diagnostic models misdiagnose a non-defective battery as defective, etc., may be used to evaluate model performance. However, general diagnostic models have a sorting power of less than 80% and a false positive rate of more than 10%, and the model performance may not be guaranteed for atypical charging/discharging patterns.

### [DISCLOSURE]

### [TECHNICAL PROBLEM]

Embodiments disclosed herein aim to provide a battery diagnosis apparatus and method with high usability even for atypical charging and discharging patterns.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to some embodiments disclosed herein includes a sensor configured to measure battery test data from a diagnosis target battery and a processor configured to classify the battery test data into a plurality of charging/discharging state data sets based on a plurality of reference values related to a plurality of charging/discharging states, perform preliminary defect diagnosis for each of the plurality of charging/discharging state data sets based on a preliminary diagnostic model, and determine the diagnosis target battery as a final defect based on a result of the preliminary defect diagnosis.

According to some embodiments, the processor may be further configured to, when determining as the final defect, determine the diagnosis target battery as the final defect when two or more data sets among the plurality charging/discharging state data sets are determined as preliminary defects.

According to some embodiments, the processor may be further configured to calculate a diagnosis rate and a false positive rate by comparing a result of determining the diagnosis target battery as the final defect with whether the diagnosis target battery is actually defective.

According to some embodiments, the plurality of charging/discharging states may include a charged state (Charge), a rest state after charged (Charge-rest), a discharged state (Discharge), and a rest state after discharged (Discharge-rest).

According to some embodiments, the processor may be further configured to sort a combination satisfying at least one of a condition that the diagnosis rate is greater than or equal to a first threshold and a condition that the over-screening rate is less than or equal to a second threshold, from among combinations including two or more states selected from among the plurality of charging/discharging states.

According to some embodiments, the battery test data may include at least one of voltage data, current data, and temperature data of the diagnosis target battery, measured for a time period of a charging/discharging test.

According to some embodiments, the preliminary diagnostic model may include at least one of support vector classifier (SVC) model, an extra-trees model, a CatBoost model, a support vector machine (SVM) model, and a long/short-term memory (LSTM) model.

A battery diagnosis method according to some embodiments disclosed herein includes measuring battery test data from a diagnosis target battery, through a sensor, dividing the battery test data into a plurality of charging/discharging state data sets based on a plurality of reference values related to a plurality of charging/discharging states, through a processor, performing preliminary defect diagnosis for each of the plurality of charging/discharging state data sets based on a preliminary diagnostic model, through the processor, and determining the diagnosis target battery as a final defect based on a result of the preliminary defect diagnosis, through the processor.

According to some embodiments, the determining as the final defect may include determining the diagnosis target battery as the final defect when two or more data sets among the plurality charging/discharging state data sets are determined as preliminary defects.

According to some embodiments, the battery diagnosis method may include calculating a diagnosis rate and a false positive rate by comparing a result of determining the diagnosis target battery as the final defect with whether the diagnosis target battery is actually defective.

According to some embodiments, the plurality of charging/discharging states may include a charged state (Charge), a rest state after charged (Charge-rest), a discharged state (Discharge), and a rest state after discharged (Discharge-rest).

According to some embodiments, the battery diagnosis method may further include sorting a combination satisfying at least one of a condition that the diagnosis rate is greater than or equal to a first threshold and a condition that the over-screening rate is less than or equal to a second threshold, from among combinations including two or more states selected from among the plurality of charging/discharging states.

According to some embodiments, the battery test data may include at least one of voltage data, current data, and temperature data of the diagnosis target battery, measured for a time period of a charging/discharging test.

According to some embodiments, the preliminary diagnostic model may include at least one of support vector classifier (SVC) model, an extra-trees model, a CatBoost model, a support vector machine (SVM) model, and a long/short-term memory (LSTM) model.

### [ADVANTAGEOUS EFFECTS]

According to embodiments disclosed herein, it is possible to provide an algorithm for dividing battery test data into a plurality of charging/discharging states and finally determining a diagnosis target battery as defective when two or more of a plurality of charging/discharging state data sets corresponding to the plurality of charging/discharging states are determined as defective, thereby diagnosing a defect of the battery with high performance without being limited to a specific charging/discharging pattern.

The technical effects according to embodiments disclosed in the present document are not limited to the effects mentioned above, and other effects not mentioned will be clearly understood by those of ordinary skill in the art according to the disclosure of the present document.

### [DESCRIPTION OF DRAWINGS]

FIG. 1 is a view showing elements of a battery diagnosis apparatus, according to some embodiments disclosed herein.
FIG. 2 is a view showing battery test data according to some embodiments disclosed herein.
FIG. 3 is a view showing a plurality of reference values representing a plurality of charging/discharging states according to some embodiments disclosed herein.
FIG. 4 is a view showing an architecture in which a charged state (Charge) according to some embodiments disclosed herein is divided into a quick charged state (QC) and a constant current charged state (CC).
FIG. 5 is a view showing a plurality of charging/discharging state data sets according to some embodiments disclosed herein.
FIG. 6 is a view showing model performance of preliminary diagnostic models according to some embodiments disclosed herein for each of a plurality of charging/discharging states.
FIG. 7 is a view showing model performance of an ensemble algorithm according to some embodiments disclosed herein.
FIG. 8 is a view showing operations of a battery diagnosis method according to some embodiments disclosed herein.

### [MODE FOR INVENTION]

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

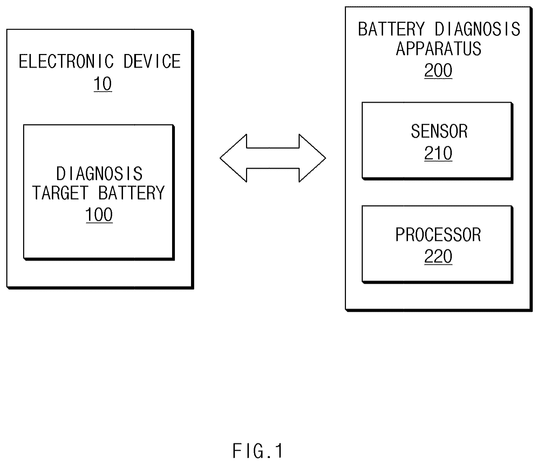

FIG. 1 is a view showing elements of a battery diagnosis apparatus, according to some embodiments disclosed herein.

Referring to FIG. 1, an electronic device 10 may include a diagnosis target battery 100, and a battery diagnosis apparatus 200 may diagnose whether the diagnosis target battery 100 is defective. The diagnosis target battery 100 and the battery diagnosis apparatus 200 may exchange data with each other through wired/wireless communication.

The electronic device 10 may mean a device using power supplied by the diagnosis target battery 100. For example, the electronic device 10 may be an electric vehicle (EV) or a hybrid EV (HEV) using electrical energy, and the diagnosis target battery 100 may be a secondary battery mounted on the EV or the HEV. Alternatively, the electronic device 10 may be a portable device such as a laptop computer, a smartphone, a tablet personal computer (PC), etc., and may be interpreted as various devices having a battery recharging function.

The diagnosis target battery 100 may be an electrical energy supply device that supplies power to the electronic device 10. For example, the diagnosis target battery 100 may be a rechargeable secondary battery discharged by supplying power to the electronic device 10 and charged by a battery charging device (not shown). According to some embodiments, the diagnosis target battery 100 may include a battery cell, a battery module, a battery pack, and/or a battery rack.

The battery diagnosis apparatus 200 may be configured to diagnose whether a cell, a module, a pack and/or a rack of the diagnosis target battery 100 is defective. The battery diagnosis apparatus 200 may include a sensor 210 and a processor 220. However, without being limited thereto, some components may be omitted from the battery diagnosis apparatus 200 or other general-purpose components may be further included in the battery diagnosis apparatus 200.

According to some embodiments, the battery diagnosis apparatus 200 may be configured integrally with a battery charging device (not shown). According to some embodiments, at least a part of the sensor 210 and the processor 220 may be mounted in the electronic device 10 instead of the battery diagnosis apparatus 200. That is, functions performed by the battery diagnosis apparatus 200 may also be performed in various devices such as not only a battery management system (BMS) in the electronic device 10, but also a server, a cloud, a charger, a charger/discharger, etc.

The diagnosis target battery 100 and the battery diagnosis apparatus 200 may be electrically connected to each other through wired/wireless communication. For example, a wireless network may be based on local area network (LAN) communication or power line communication, and the wireless network may be based on a short-range communication network such as Bluetooth, Wireless Fidelity (WiFi), Infrared data association (IrDA), etc., and/or a long-range communication network such as a cellular network, a 4th-generation (4G) network, and a 5th-generation (5G) network. According to some embodiments, a communication scheme among the diagnosis target battery 100 and the battery diagnosis apparatus 200 may be a communication scheme between devices such as a general purpose input and output (GPIO), a serial peripheral interface (SPI), a mobile industry processor interface (MIPI), etc.

The sensor 210 may be configured to measure battery test data from the diagnosis target battery 100 during a charging/discharging test. According to an embodiment, the charging/discharging test may mean application of voltage or current in a specific form to inspect whether a cell, a module, a pack, etc., of the diagnosis target battery 100 has a detect. For example, the battery test data measured from the diagnosis target battery 100 by the sensor 210 may include at least one of voltage data, current data, and temperature data of the diagnosis target battery 100 measured in a time period of the charging/discharging test.

The sensor 210 may include at least one sensor for measuring battery-related data such as voltage, current, and/or temperature from the diagnosis target battery 100.

The processor 220 may have a structure for executing instructions that implement the operations of the battery diagnosis apparatus 200. The processor 220 may be implemented with an array of multiple logic gates or a general-purpose microprocessor for processing various operations, and may include a single processor or a plurality of processors. For example, the processor 220 may be implemented in the form of at least one of a microprocessor, a CPU, a GPU, and an AP.

The processor 220 may be configured separately from or integrally with a memory (not shown) configured to store instructions, and may process various operations by executing the instructions stored in a memory module. The memory module may store various data, instructions, mobile applications, computer programs, etc. For example, the memory module may be implemented in the form of non-volatile memory such as ROM, PROM, EPROM, EEPROM, flash memory, PRAM, MRAM, RRAM, FRAM, etc., volatile memory such as DRAM, SRAM, SDRAM, RRAM, FeRAM, etc., or HDD, SSD, SD, Micro- SD, etc., or may be implemented in the form of a combination thereof.

The processor 220 may be configured to divide the battery test data into the plurality of charging/discharging state data sets based on the plurality of reference values representing the plurality of charging/discharging states. According to an embodiment, the plurality of reference values may include a voltage value, a current value, or a temperature value.

The diagnosis target battery 100 may have any one of the plurality of charging/discharging states. According to an embodiment, a type of a charging/discharging state may be determined according to a voltage value or a current value applied to the diagnosis target battery 100. For example, when the battery test data is a voltage measured from the diagnosis target battery 100 in a charging/discharging test period, the charging/discharging test period may be divided into a plurality of periods according to a specific criterion and any one charging/discharging state may be allocated to each of the plurality of periods. Herein, the specific criterion for dividing the charging/discharging test period into the plurality of periods may be an equal time interval, and other criterion may be used.

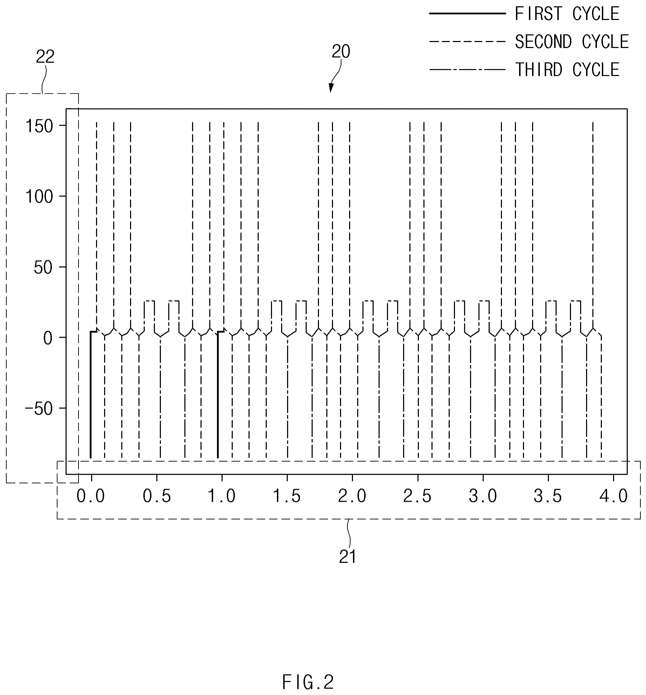

For example, when four charging/discharging states are used, a charging/discharging state of each of the plurality of periods into which the charging/discharging test period is divided may be determined based on to which of the four reference values a representative value such as an average voltage value of each period is closest. A set of periods having the same charging/discharging state may be a data set of a corresponding charging/discharging state, and thus the battery test data may be divided into four charging/discharging state data sets. More specifically, this may refer to FIGS. 2 to 5 described below.

The processor 220 may be configured to perform preliminary defect diagnosis for each of the plurality of charging/discharging state data sets based on a preliminary diagnostic model. Herein, the preliminary diagnostic model may be any one or a combination of various prediction models for diagnosing a battery defect. For example, the preliminary diagnostic model may include a support vector classifier (SVC) model, an extra-trees model, a CatBoost model, a support vector machine (SVM) model, a long/short-term memory (LSTM) model, etc.

The processor 220 may diagnose a state of the diagnosis target battery 100 based on a result of the preliminary defect diagnosis. According to an embodiment, the processor 220 may be configured to determine the diagnosis target battery 100 as a final defect when two or more of the plurality of charging/discharging state data sets are determined as preliminary defects, as the result of the preliminary defect diagnosis. herein, the final defect may mean a defect according to an ensemble algorithm. For example, when the four charging/discharging states are used, the battery test data may be divided into four charging/discharging state data sets for which four preliminary diagnosis results (defect diagnosis T or F) may be obtained. Herein, when the two or more preliminary diagnosis results are determined as defects (T), the diagnosis target battery 100 may be determined as a final defect. Meanwhile, the number of criteria for determining a final defect may be determined as any one of 2, 3, and 4 according to performance conditions such as a minimum sorting power, a maximum over-screening rate, etc.

According to the foregoing aspect, the processor 220 may be understood as diagnosing a state of the diagnosis target battery 100 based on the ensemble algorithm. According to embodiments, the ensemble algorithm may mean an algorithm for determining whether the diagnosis target battery 100 is a final defect, by using a plurality of diagnosis results for the plurality of charging/discharging state data sets of the preliminary diagnostic model.

That is, the ensemble algorithm may subdivide a defect diagnosis result for the plurality of charging/discharging states and use a combination thereof, thereby having stable sorting power and over-screening rate for a general charging/discharging pattern. To this end, preliminary defect diagnosis may be performed for each of the plurality of charging/discharging state data sets through a preliminary diagnostic model.

According to some embodiments, the processor 220 may be further configured to calculate a diagnosis rate and a false positive rate for determining the diagnosis target battery 100 as a final defect.

For example, the diagnosis target battery 100 may include a plurality of battery cells, and it may be known in advance which cells among the plurality of battery cells are defective cells. A diagnosis rate may be calculated according to whether the ensemble algorithm correctly diagnoses whether the plurality of battery cells are defective, and a false positive rate may be calculated according to a rate of determining a non-defective cell as a defective cell.

According to some embodiments, the plurality of charging/discharging states may include a charged state Charge, a rest state after charged Charge-rest, a discharged state Discharge, and a rest state after discharged Discharge-rest.

For example, the four charging/discharging states may indicate a current state the inspection target battery 100 has and may be classified based on a battery voltage. The charged state Charge may correspond to a high-strength positive voltage, the rest state after charged Charge-rest may correspond to a low-strength positive voltage, the rest state after discharged Discharge-rest may correspond to a high-strength negative voltage, and the discharged state Discharge may correspond to the low-strength negative voltage. According to some embodiments, the charged state Charge may be classified into the quick charged state QC and the constant current charged state CC, such that a total of five charging/discharging states may be used.

According to some embodiments, the processor 220 may be further configured to sort a combination satisfying at least one of a condition that a diagnosis rate is greater than or equal to a first threshold and a condition that a false positive rate is less than or equal to a second threshold, from among combinations including two or more states selected from among a plurality of charging/discharging states.

For example, when four charging/discharging states are used, there may be six cases of combination of two charging/discharging states, four cases of combination of three charging/discharging states, and one case of combination of four charging/discharging states. Among such eleven types of combinations, a combination having high model performance may be selected based on a diagnosis rate and a false positive rate. More specifically, when the preliminary diagnostic model is the SVM and a combination of the rest state after charged Charge-rest and the rest state after discharged Discharge-rest shows a high diagnosis rate and a low over-screening rate, the corresponding combination may be matched to the SVM model and stored in the battery diagnosis apparatus 200.

According to some embodiments, the preliminary diagnostic model may include at least one of an SVC model, an extra-trees model, a CatBoost model, an SVM model, and an LSTM model.

As such, the exemplified models may correspond to algorithms conventionally used for battery defect diagnosis, and may be used as the preliminary diagnostic model in the ensemble algorithm. As described above, a combination of charging/discharging states, matched to each model, may be analyzed. Various other algorithms and models available for battery defect diagnosis as well as the exemplified models may also be used as preliminary diagnosis models.

FIG. 2 is a view showing battery test data according to some embodiments disclosed herein.

Referring to FIG. 2, a graph 20 showing battery test data measured from the diagnosis target battery 100 during a charging/discharging test may be shown. The battery test data of the graph 20 may be pre-processed data to which processes for the ensemble algorithm are not applied. For example, on the graph 20, a horizontal axis 21 may indicate a time and a vertical axis 22 may indicate a voltage.

The battery test data of the graph 20 may be divided by a plurality of cycles. For example, each cycle may be any one of first to third cycles. However, the present disclosure is not limited thereto, and the battery test data may indicate current or voltage and may have more or less cycles. Meanwhile, the battery test data may have an atypical general pattern rather than a combination of charging/discharging cycles.

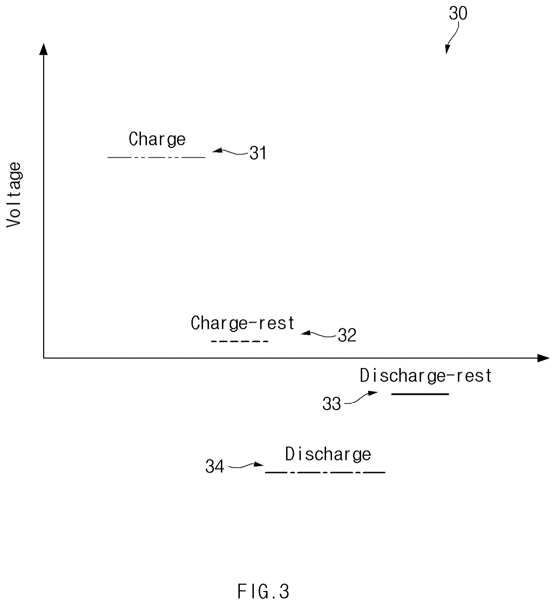

FIG. 3 is a view showing a plurality of reference values representing a plurality of charging/discharging states according to some embodiments disclosed herein.

Referring to FIG. 3, a graph 30 showing a plurality of reference values representing a plurality of charging/discharging states may be shown. Each reference value of the graph 30 may mean a voltage level corresponding to each charging/discharging state.

For example, the battery test data may be voltage data measured during the charging/discharging test, and four charging/discharging states may be used. For the four charging/discharging states, a charged state reference value 31, a rest state after charged reference value 32, a discharged state reference value 33, and a rest state after discharged reference value 34 may be set. Each charging/discharging state may mean a voltage in a specific range, and an average or a mean value representing the range, or other various types of representative values may be set as reference values.

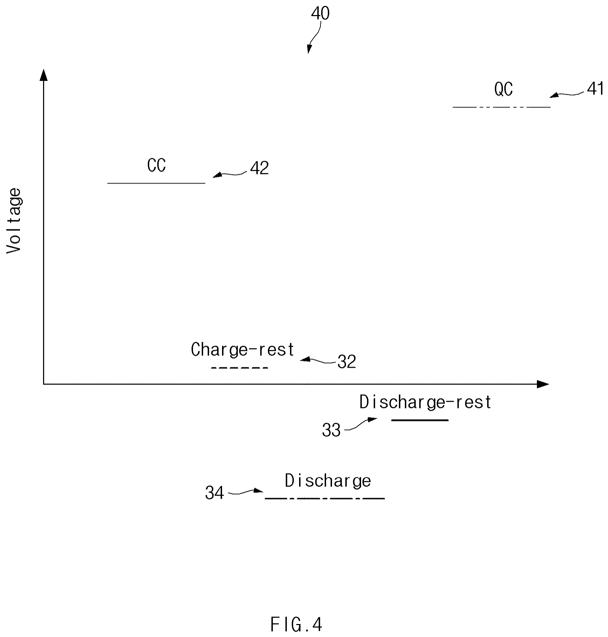

FIG. 4 is a view showing an architecture in which a charged state Charge according to some embodiments disclosed herein is divided into a quick charged state QC and a constant current charged state CC.

Referring to FIG. 4, a graph 40 may be shown, which indicates a structure in which the charged state Charge is classified into the quick charged state QC and the constant current charged state CC. On the graph 40, the charged state reference value 31 may be subdivided into a quick charged state reference value 41 and a constant current charged state reference value 42.

The charged state Charge may be classified into the quick charged state QC corresponding to a higher voltage range and the constant current charged state CC corresponding to a lower voltage range, such that the reference value may also be subdivided. By subdividing the charged state Charge having the widest range among the four charging/discharging states including the charged state Charge, the rest state after charged Charge-rest, the discharged state Discharge, and the rest state after discharged Discharge-rest into two states, the ensemble algorithm may operate more precisely.

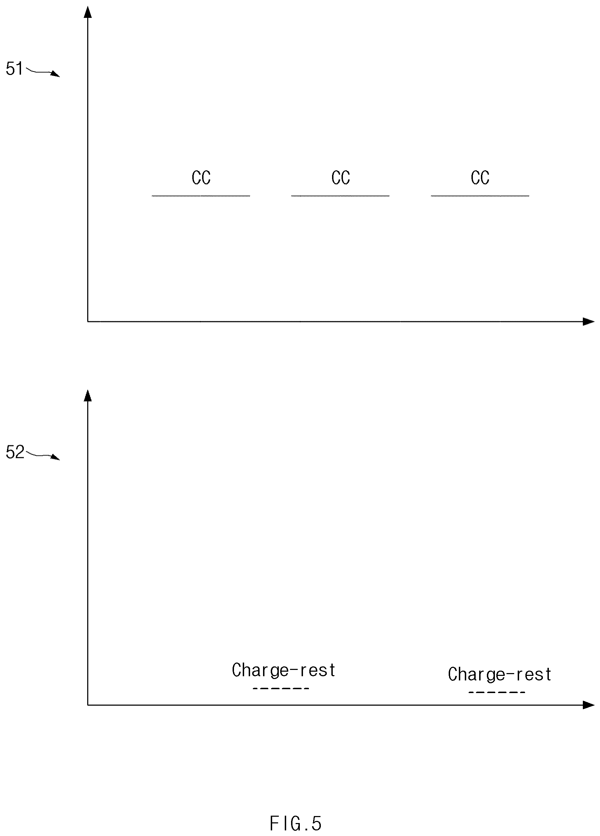

FIG. 5 is a view showing a plurality of charging/discharging state data sets according to some embodiments disclosed herein.

Referring to FIG. 5, among five charging/discharging state data sets corresponding to five charging/discharging states, a constant current charged state data set 51 and a rest state after charged data set 52 may be shown.

Among five charging/discharging state data sets, three data sets not shown, i.e., a quick charged state data set, a discharged state data set, and a rest state after discharged may also be generated in the same manner. Each charging/discharging state data set may be a subset of battery test data. For example, by summing five charging/discharging state data sets, the battery test data of the graph 20 may be formed.

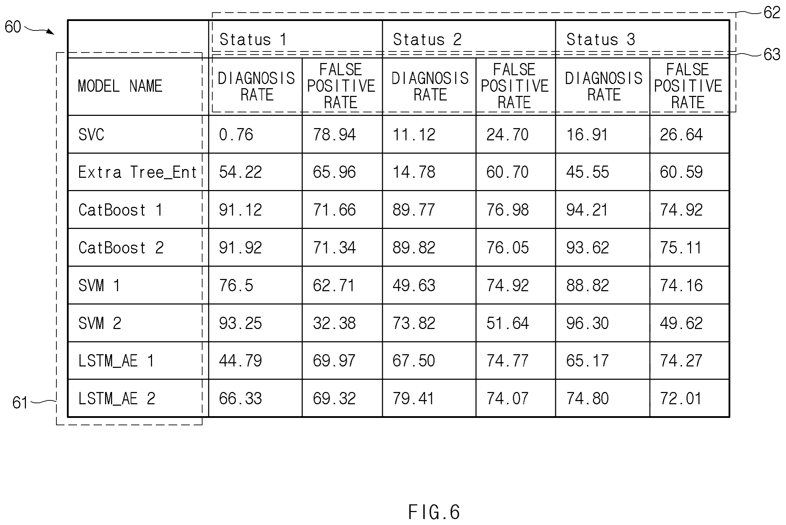

FIG. 6 is a view showing model performance of preliminary diagnostic models according to some embodiments disclosed herein for each of a plurality of charging/discharging states.

Referring to FIG. 6, a table 60 indicating a diagnosis rate and a false positive rate of preliminary diagnostic models for each of a plurality of charging/discharging states may be shown. A first column 61 of the table 60 may indicate a model name of a preliminary diagnostic model, a first row 62 of the table 60 may indicate a charging/discharging state, and a second row 63 of the table 60 may indicate identification of a diagnosis rate and a false positive rate.

The charging/discharging state of the first row 62 may mean three states among four charging/discharging states including the charged state Charge, the rest state after charged Charge-rest, the discharged state Discharge, and the rest state after discharged Discharge-rest. Alternatively, the charging/discharging state of the first row 62 may mean three states among five charging/discharging states including the quick charged state QC, the constant current charged state CC, the rest state after charged Charge-rest, the discharged state Discharge, and the rest state after discharged Discharge-rest.

For example, preliminary diagnostic models of the first column 61 may mean conventionally used battery defect diagnostic models. As in value fields of the table 60, it may be seen that the preliminary diagnostic models of the first column 61 show high diagnosis rate values in some thereof, but there is no model having both a high diagnosis rate and a low over-screening rate.

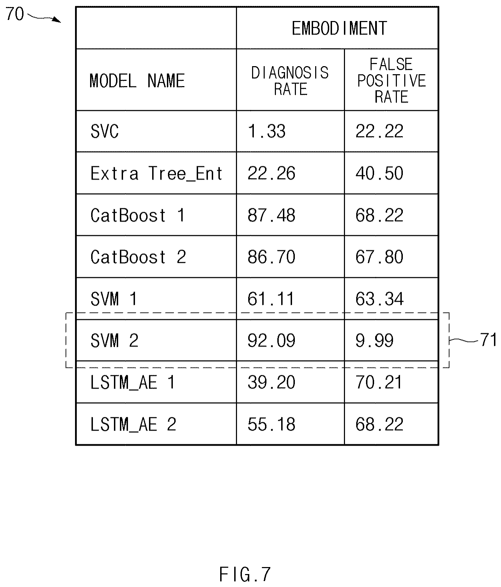

FIG. 7 is a view showing model performance of an ensemble algorithm according to some embodiments disclosed herein.

Referring to FIG. 7, a table 70 for describing the model performance of the ensemble algorithm may be shown. For example, the table 70 may show an ensemble algorithm in which two or more states among three charging/discharging states of the first row 62 are determined as final defects when they are determined as preliminary defects.

For example, two or more states among the three charging/discharging states of the first row 62 may be any one having the highest performance among four combinations (status 1 and status 2), (status 1 and status 3), (status 2 and status 3), and (status 1, status 2, status 3). As in the table 70, when the preliminary diagnostic model is "SVM2", a diagnosis rate over 90 % and a false positive rate below 10 % may be achieved by the ensemble algorithm.

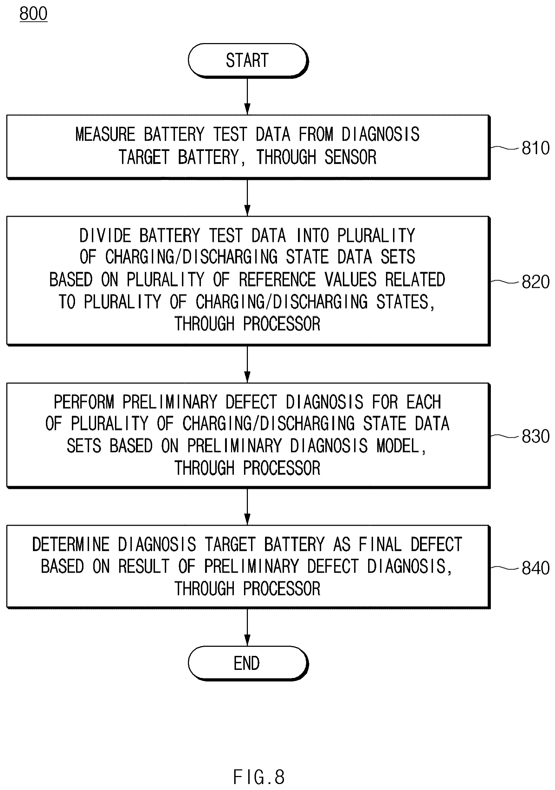

FIG. 8 is a view showing operations of a battery diagnosis method according to some embodiments disclosed herein.

Referring to FIG. 8, a battery diagnosis method 800 may include operations 810 to 850. However, without being limited thereto, some operations may be omitted and other general-purpose operations may be added, and operations of the battery diagnosis method 800 may be executed in an order different from that shown.

The battery diagnosis method 800 may include operations processed in time series by the battery diagnosis apparatus 200. Therefore, matters described for the battery diagnosis apparatus 200 above, even omitted below, may be equally applied to the battery diagnosis method 800.

Operations 810 to 850 of the battery diagnosis method 800 may be performed by the sensor 210 and the processor 220 of the battery diagnosis apparatus 200.

In operation 810, the battery diagnosis apparatus 200 may measure battery test data from a diagnosis target battery through a sensor.

In operation 820, the battery diagnosis apparatus 200 may divide the battery test data into the plurality of charging/discharging state data sets based on the plurality of reference values related to the plurality of charging/discharging states, through the processor.

In operation 830, the battery diagnosis apparatus 200 may perform preliminary defect diagnosis for each of the plurality of charging/discharging state data sets based on a preliminary diagnostic model, through the processor.

In operation 840, the battery diagnosis apparatus 200 may determine the diagnosis target battery as a final defect based on a result of the preliminary defect diagnosis, through the processor.

Meanwhile, the battery diagnosis method 800 may be implemented in the form of a computer program stored in a computer-readable storage medium. That is, the computer program may include instructions for implementing the battery diagnosis method 800, and the instructions of the program may be stored in a computer-readable storage medium. The computer programs may include mobile applications.

For example, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as read only memory (ROM), random access memory (RAM) and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

### [DESCRIPTION OF SYMBOLS]

| | | | |
|---|---|---|---|
| 10: | Electronic Device | 100: | Diagnosis Target Battery |
| 200: | Battery Diagnosis Apparatus | 210: | Sensor |
| 220: | Processor | | |

## Claims

1. A battery diagnosis apparatus comprising:
a sensor configured to measure battery test data from a diagnosis target battery; and
a processor configured to:
classify the battery test data into a plurality of charging/discharging state data sets based on a plurality of reference values related to a plurality of charging/discharging states;
perform preliminary defect diagnosis for each of the plurality of charging/discharging state data sets based on a preliminary diagnostic model: and
determine the diagnosis target battery as a final defect based on a result of the preliminary defect diagnosis.

2. The battery diagnosis apparatus of claim 1, wherein the processor is further configured to, when determining as the final defect, determine the diagnosis target battery as the final defect when two or more data sets among the plurality charging/discharging state data sets are determined as preliminary defects.

3. The battery diagnosis apparatus of claim 1, wherein the processor is further configured to calculate a diagnosis rate and a false positive rate by comparing a result of determining the diagnosis target battery as the final defect with whether the diagnosis target battery is actually defective.

4. The battery diagnosis apparatus of claim 3, wherein the plurality of charging/discharging states comprise a charged state (Charge), a rest state after charged (Charge-rest), a discharged state (Discharge), and a rest state after discharged (Discharge-rest).

5. The battery diagnosis apparatus of claim 4, wherein the processor is further configured to sort a combination satisfying at least one of a condition that the diagnosis rate is greater than or equal to a first threshold and a condition that the over-screening rate is less than or equal to a second threshold, from among combinations including two or more states selected from among the plurality of charging/discharging states.

6. The battery diagnosis apparatus of claim 1, wherein the battery test data comprises at least one of voltage data, current data, and temperature data of the diagnosis target battery, measured for a time period of a charging/discharging test.

7. The battery diagnosis apparatus of claim 1, wherein the preliminary diagnostic model comprises at least one of support vector classifier (SVC) model, an extra-trees model, a CatBoost model, a support vector machine (SVM) model, and a long/short-term memory (LSTM) model.

8. A battery diagnosis method comprising:
measuring battery test data from a diagnosis target battery, through a sensor;
dividing the battery test data into a plurality of charging/discharging state data sets based on a plurality of reference values related to a plurality of charging/discharging states, through a processor;
performing preliminary defect diagnosis for each of the plurality of charging/discharging state data sets based on a preliminary diagnostic model, through the processor; and
determining the diagnosis target battery as a final defect based on a result of the preliminary defect diagnosis, through the processor.

9. The battery diagnosis method of claim 8, wherein the determining as the final defect comprises determining the diagnosis target battery as the final defect when two or more data sets among the plurality charging/discharging state data sets are determined as preliminary defects.

10. The battery diagnosis method of claim 8, further comprising calculating a diagnosis rate and a false positive rate by comparing a result of determining the diagnosis target battery as the final defect with whether the diagnosis target battery is actually defective.

11. The battery diagnosis method of claim 10, wherein the plurality of charging/discharging states comprise a charged state (Charge), a rest state after charged (Charge-rest), a discharged state (Discharge), and a rest state after discharged (Discharge-rest).

12. The battery diagnosis method of claim 11, further comprising sorting a combination satisfying at least one of a condition that the diagnosis rate is greater than or equal to a first threshold and a condition that the over-screening rate is less than or equal to a second threshold, from among combinations including two or more states selected from among the plurality of charging/discharging states.

13. The battery diagnosis method of claim 8, wherein the battery test data comprises at least one of voltage data, current data, and temperature data of the diagnosis target battery, measured for a time period of a charging/discharging test.

14. The battery diagnosis method of claim 8, wherein the preliminary diagnostic model comprises at least one of support vector classifier (SVC) model, an extra-trees model, a CatBoost model, a support vector machine (SVM) model, and a long/short-term memory (LSTM) model.
